(19) **Europäisches Patentamt**
**European Patent Office**
**Office européen des brevets**

(11) **EP 3 083 828 B1**

(12) **EUROPEAN PATENT SPECIFICATION**

(45) Date of publication and mention
of the grant of the patent:
**20.09.2017 Bulletin 2017/38**

(21) Application number: **14811844.1**

(22) Date of filing: **10.12.2014**

(51) Int Cl.:
*C08L 67/02* (2006.01)     *G02B 1/04* (2006.01)
*C08K 3/22* (2006.01)      *C08L 77/06* (2006.01)
*H01L 33/60* (2010.01)     *F21V 7/22* (2006.01)
*C08K 3/30* (2006.01)

(86) International application number:
**PCT/EP2014/077111**

(87) International publication number:
**WO 2015/091119 (25.06.2015 Gazette 2015/25)**

(54) **POLYESTER COMPOSITIONS WITH IMPROVED WHITENESS**

POLYESTERZUSAMMENSETZUNGEN MIT ERHÖHTER WEISSHEIT

COMPOSITIONS DE POLYESTER À BLANCHEUR AMÉLIORÉE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **20.12.2013 US 201361919211 P**

(43) Date of publication of application:
**26.10.2016 Bulletin 2016/43**

(73) Proprietor: **Solvay Specialty Polymers USA, L.L.C. Alpharetta, GA 30005-3149 (US)**

(72) Inventors:
• **BONGIOVANNI, Alessandro**
  **Alpharetta, GA 30022 (US)**

• **DESIO, Glenn, P.**
  **Marietta, GA 30062 (US)**
• **CUPTA, Glenn, W.**
  **Roswell, GA 30075 (US)**
• **WOOD, Thomas, Alton, Jr.**
  **Cumming, Georgia 30041 (US)**

(74) Representative: **Benvenuti, Federica et al Solvay S.A.**
**Département de la Propriété Intellectuelle**
**Rue de Ransbeek, 310**
**1120 Bruxelles (BE)**

(56) References cited:
**EP-A1- 1 454 957     WO-A1-02/081564**
**WO-A1-2013/101277     JP-A- H0 384 060**
**US-A- 4 066 587**

**Description**

**Field of the Invention**

The present invention relates to polymeric compositions comprising at least one polyester and at least one polyamide with improved whiteness and excellent retention of light reflectance.

The present invention further provides an article comprising the composition of the invention, such as a part of a light emitting diode (LED) device.

**Background of the Invention**

LEDs are increasingly being used as light sources in numerous applications due to the high number of benefits they provide over traditional light sources. LEDs generally consume significantly less power than other light sources, require a low voltage to operate, and are resistant to mechanical shock. As a result, they are displacing incandescent and other light sources in many uses and have found applications in such disparate areas as traffic signals, interior and exterior lighting, cellular telephone displays, automotive displays, and flashlights.

LED components, such as reflectors, require an especially demanding combination of excellent color and improved physical properties. Ceramics may be advantageously used in those applications, but are still extremely costly and require demanding processing technologies. Therefore, polymers have been extensively studied and developed to replace ceramics as a lower cost material. A great benefit of thermoplastic polymers is that they may be injection molded and therefore offer considerable design flexibility. One problem noted with the polymer compositions used for the manufacture of LED components is that they tend to yellow when exposed to light and elevated temperatures. For example, during manufacturing, the LED components are heated to about 160°C to cure an epoxy or silicon encapsulant. The LED components are also exposed to temperatures above 260°C while soldering operations are performed. In addition, while in use, LED components are routinely subjected to light and temperatures above 80°C. Moreover, the recent development of higher voltage LEDs leads to even higher working temperatures, generally above 100°C. This concurrent exposure to light and high temperatures causes yellowing of polymer compositions used for forming LED components.

Desirably, reflectors of LEDs and, *in fine*, the polymer compositions from which they are made, should comply with a wide set of requirements, including, notably, high reflectance of light, high whiteness, high dimensional stability, high mechanical strength, high heat deflection temperature, and high heat resistance (low discoloration and low loss of reflectance when exposed to a high temperature) while being easily processed into the desired shapes.

Polyesters are often used to manufacture shaped articles for use in a wide range of applications, including films, sheets, profiles, bottles, and the like. The most commonly used polyesters are based on terephthalic acid or 2,6-naphthalene dicarboxylic acid, and include, for example, poly(ethylene terephthalate) ("PET"), poly(1,4-butylene terephthalate) ("PBT"), poly(cyclohexylenedimethylene terephthalate) ("PCT"), poly(cyclohexylenedimethylene naphthalate) ("PCN"), poly(ethylene naphthalate) ("PEN") and their copolyesters. These polyesters are relatively inexpensive, widely available and, because of their aromatic content, have a high glass transition temperature (Tg), which gives shaped articles made there from thermal resistance, stiffness and toughness.

PCT is currently used for the manufacture of LED's because of its great overall properties. However, in spite of these positive characteristics, there is still a need in the market to improve the whiteness and whiteness retention of LED reflectors.

Certain polyamides are also used in the manufacture of LED reflector where their good initial whiteness is valued. However, those polyamides suffer from yellowing when submitted to heat and/or light.

One of ordinary skill in the art will recognize that further improvements in heat stability and reflectance are advantageous for the development of LED devices.

WO 2007/033129 discloses light-emitting diode assembly housings comprising PCT compositions comprising titanium dioxide, inorganic reinforcing agents or fillers, and oxidative stabilizers. Those compositions suffer from a very low whiteness index even after very mild heat treatment.

US 2012/0262927 relates to compositions suitable for molding LED reflectors comprising PCT, a white pigment and a reactive viscosity stabilizer such as a phenoxy resin or a non-aromatic epoxy resin. US'927 discloses in its examples PCT compositions comprising titanium dioxide, chopped glass fibers, 2 wt. % of talc and 8 other additives. Those compositions only achieve a maximum of about 84 % of whiteness index retention after 4 hours at 200°C.

WO 2012/141967 discloses certain white PCT-based polymer compositions. Unfortunately, none of the exemplified compositions show acceptable after aging reflectance data that would render them suitable for LED applications.

Thus, there exists a need in the art for a polymer composition featuring all the benefits of polyesters while presenting a higher initial whiteness and at least maintaining low discoloration during heat and/or light treatment.

The inventors have discovered that the blending of certain polyesters with specific polyamides greatly enhances the behavior of certain white pigmented polyester compositions in terms of initial whiteness while maintaining an excellent reflectance after heat and light exposure.

The compositions according to the present invention satisfy thus the above-mentioned requirements and will be described in detail hereafter.

## Summary of the Invention

In a first aspect, the present invention relates to a polymer composition (C) comprising :

- from 20 to 60 wt. % of at least one polyester (P) comprising at least 50 mol % of recurring units comprising at least one cycloaliphatic group,
- from 0.5 to 20 wt. % of at least one polyamide (PA) comprising at least 50 mol % of recurring units comprising an aliphatic moiety comprising at least 9 carbon atoms,
- from 0 to 60 wt. % of at least one white pigment selected from the group consisting of $TiO_2$, ZnS, ZnO, $CeO_2$ and $BaSO_4$,
- from 0 to 60 wt. % of at least one reinforcing filler

based on the total weight of the polymer composition (C).

In a second aspect, the present invention relates to articles comprising at least one part comprising the invented polymer composition (C) and, in particular, to parts of LED devices made from such polymer composition (C).

## Detailed Description of the Invention

The polymer composition (C) according to the present invention comprises two essential ingredients that are described in detail here below : *The polyester (P)*

The polymer composition (C) comprises a polyester (P) comprising at least 50 mol % of recurring units comprising at least one cycloaliphatic group.

The term "polyester" is intended to include "copolyesters" and is understood to denote a polymer comprising at least 50 mol %, preferably at least 85 mol % of recurring units comprising at least one ester moiety (commonly described by the formula : R-(C=O)-OR'). Polyesters may be obtained by ring opening polymerization of a cyclic monomer ($M_A$) comprising at least one ester moiety; by polycondensation of a monomer ($M_B$) comprising at least one hydroxyl group and at least one carboxylic acid group, or by polycondensation of at least one monomer ($M_C$) comprising at least two hydroxyl groups (a diol) and at least one monomer ($M_D$) comprising at least two carboxylic acid groups (a dicarboxylic acid). As used herein, the term dicarboxylic acid is intended to include dicarboxylic acids and any derivative of dicarboxylic acids, including their associated acid halides, esters, half-esters, salts, half-salts, anhydrides, mixed anhydrides, or mixtures thereof.

The polyester (P) comprises at least 50 mol %, preferably at least 60 mol %, more preferably at least 70 mol %, still more preferably at least 80 mol % and most preferably at least 90 mol % of recurring units comprising, in addition to the at least one ester moiety, at least one cycloaliphatic group. Excellent results were obtained when the polyester (P) was essentially composed of recurring units comprising at least one ester moiety and at least one cycloaliphatic group. The cycloaliphatic group may derive from monomers ($M_A$), monomers ($M_B$), monomers ($M_C$) or monomers ($M_D$) comprising at least one group which is both aliphatic and cyclic.

Non limitative examples of monomers ($M_A$) include lactide and caprolactone.

Non limitative examples of monomers ($M_B$) include glycolic acid, 4-hydroxybenzoic acid and 6-hydroxynaphthalene-2-carboxylic acid.

Non limitative examples of monomers ($M_C$) include 1,4-cyclohexanedimethanol, ethylene glycol, 1,2-propanediol, 1,3-propanediol, 1,4-butanediol, 1,5-pentanediol, 1,6-hexanediol, 1,8-octanediol, 1,10-decanediol, 2,2,4-trimethyl 1,3-pentanediol, 2,2,4,4-tetramethyl-1,3-cyclobutanediol, and neopentyl glycol, while 1,4-cyclohexanedimethanol and neopentyl glycol are preferred.

Non limitative examples of monomers ($M_D$) include terephthalic acid, isophthalic acid, naphthalene dicarboxylic acids, 1,4-cyclohexane dicarboxylic acid, succinic acid, sebacic acid, and adipic acid, while terephthalic acid and 1,4-cyclohexane dicarboxylic acid are preferred.

When the polyester (P) is a copolymer, monomers ($M_C$) and ($M_D$) are preferably used. In such a case, monomer ($M_C$) is preferably 1,4-cyclohexanedimethanol and monomer ($M_D$) is preferably a mixture of terephthalic acid and 1,6-naphthalene dicarboxylic acid.

When the polyester (P) is a homopolymer, it may be selected from poly(cyclohexylenedimethylene terephthalate) ("PCT") and poly(cyclohexylenedimethylene naphthalate) ("PCN"). Most preferably, it is PCT (i.e. a homopolymer obtained through the polycondensation of terephthalic acid with 1,4-cyclohexylenedimethanol).

The polyester (P) has a melting point, as measured by DSC according to ISO-11357-3, of advantageously at least 250°C, preferably at least 260°C, more preferably at least 270°C and most preferably at least 280°C. Besides, its melting point is advantageously of at most 350°C, preferably at most 340°C, more preferably at most 330°C and most preferably at most 320°C. Excellent results were obtained with a polyester (P) having a melting point ranging from 280°C to 320°C.

The polyester (P) is preferably present in an amount of at least 20 wt. %, more preferably at least 25 wt. %, still more preferably at least 30 wt. %, and most preferably at least 35 wt. %, based on the total weight of the polymer composition (C).

The polyester (P) is also present in an amount of advantageously at most 70 wt. %, preferably at most 65 wt. %, more preferably at most 60 wt. %, still more preferably at most 55 wt. %, and most preferably at most 50 wt. %, based on the total weight of the polymer composition (C).

Excellent results were obtained when the polyester (P) was present in the polymer composition (C) in an amount from about 30 to about 60 wt. %, preferably from about 35 to about 45 wt. %, based on the total weight of the polymer composition (C).

The polymer composition (C) may comprise more than one polyester *(P).The polyamide (PA)*

The polymer composition (C) comprises a polyamide (PA) comprising at least 50 mol % of recurring units ($R_{PA}$) comprising an aliphatic moiety comprising at least 9 carbon atoms.

The expression "polyamide" is intended to denote any polymer which comprises amide bonds. The recurring units ($R_{PA}$) are typically derived from the polycondensation of at least one dicarboxylic acid component (or derivative thereof) and at least one diamine component, and/or from the polycondensation of aminocarboxylic acids and/or lactams.

The expression 'derivative thereof when used in combination with the expression 'carboxylic acid' is intended to denote whichever derivative which is susceptible of reacting in polycondensation conditions to yield an amide bond. Examples of amide-forming derivatives include a mono- or di-alkyl ester, such as a mono- or di-methyl, ethyl or propyl ester, of such carboxylic acid; a mono-or di-aryl ester thereof; a mono- or di-acid halide thereof; and a mono-or di-acid amide thereof, a mono- or di-carboxylate salt.

In certain preferred embodiment, the polyamide (PA) of the polymer composition (C) comprises at least 50 mol %, preferably at least 60 mol %, more preferably at least 70 mol %, still more preferably at least 80 mol % and most preferably at least 90 mol % of recurring units ($R_{PA}$). Excellent results were obtained when the polyamide (PA) of the polymer composition (C) consisted of recurring units ($R_{PA}$).

The polyamide (PA) of the polymer composition (C) may be an aliphatic polyamide polymer or an aromatic polyamide polymer.

For the purpose of the present invention, the expression "aromatic polyamide polymer" is intended to denote a polyamide which comprises more than 35 mol %, preferably more than 45 mol %, more preferably more than 55 mol %, still more preferably more than 65 mol % and most preferably more than 75 mol % of recurring units ($R_{PA}$) which are aromatic recurring units.

For the purpose of the present invention, the expression "aromatic recurring unit" is intended to denote any recurring unit that comprises at least one aromatic group. The aromatic recurring units may be formed by the polycondensation of at least one aromatic dicarboxylic acid with an aliphatic diamine or by the polycondensation of at least one aliphatic dicarboxylic acid with an aromatic diamine, or by the polycondensation of aromatic aminocarboxylic acids.

For the purpose of the present invention, a dicarboxylic acid or a diamine is considered as "aromatic" when it comprises at least one aromatic group.

Non limitative examples of aromatic dicarboxylic acids are notably phthalic acids, including isophthalic acid (IA), terephthalic acid (TA) and orthophthalic acid (OA), 2,5-pyridinedicarboxylic acid, 2,4-pyridinedicarboxylic acid, 3,5-pyridinedicarboxylic acid, 2,2-bis(4-carboxyphenyl)propane, bis(4-carboxyphenyl)methane, 2,2-bis(4-carboxyphenyl)hexafluoropropane, 2,2-bis(4-carboxyphenyl)ketone, 4,4'-bis(4-carboxyphenyl)sulfone, 2,2-bis(3-carboxyphenyl)propane, bis(3-carboxyphenyl)methane, 2,2-bis(3-carboxyphenyl)hexafluoropropane, 2,2-bis(3-carboxyphenyl)ketone, bis(3-carboxyphenoxy)benzene, the 2,6-naphthalene dicarboxylic acid, 2,7-naphthalene dicarboxylic acid,1,4-naphthalene dicarboxylic acid, 2,3-naphthalene dicarboxylic acid, 1,8-naphthalene dicarboxylic acid, 1,2-naphthalene dicarboxylic acid.

Among aromatic diamines, mention can be notably made of metaphenylene diamine (MPD), para-phenylene diamine (PPD), 3,4'-diaminodiphenyl ether (3,4'-ODA), 4,4'-diaminodiphenyl ether (4,4'-ODA), meta-xylylene diamine (MXDA), and para-xylylene diamine (PXDA).

According to preferred embodiments of the present invention, the dicarboxylic acid is aromatic and comprises advantageously at least one phthalic acid selected from the group consisting of isophthalic acid (IA), and terephthalic acid (TA). Isophthalic acid and terephthalic acid can be used alone or in combination. The phthalic acid is preferably terephthalic acid, optionally in combination with isophthalic acid.

For the purpose of the present invention, the expression "aliphatic polyamide polymer" is intended to denote a polyamide that comprises aliphatic recurring units exclusively and said aliphatic recurring units are derived from at least one aliphatic dicarboxylic acid, as mentioned above, and at least one aliphatic diamine, and/or said aliphatic recurring units are derived from aliphatic aminocarboxylic acids and/or aliphatic lactams.

Among aliphatic dicarboxylic acids, mention can be notably made of oxalic acid [HOOC-COOH, malonic acid (HOOC-CH$_2$-COOH), adipic acid [HOOC-(CH$_2$)$_4$-COOH], succinic acid [HOOC-(CH$_2$)$_2$-COOH], glutaric acid [HOOC-(CH$_2$)$_3$-COOH], 2,2-dimethyl-glutaric acid [HOOC-C(CH$_3$)$_2$-(CH$_2$)$_2$-COOH], 2,4,4-trimethyl-adipic acid [HOOC-CH(CH$_3$)-CH$_2$-C(CH$_3$)$_2$-CH$_2$-COOH], pimelic acid [HOOC-(CH$_2$)$_5$-COOH], suberic acid [HOOC-(CH$_2$)$_6$-COOH], azelaic acid [HOOC-(CH$_2$)$_7$-COOH], sebacic acid [HOOC-(CH$_2$)$_8$-COOH], undecanedioic acid [HOOC-(CH$_2$)$_9$-COOH], dodecanedioic acid [HOOC-(CH$_2$)$_{10}$-COOH], tetradecanedioic acid [HOOC-(CH$_2$)$_{11}$-COOH], cis- and/or trans-cyclohexane-1,4-dicarboxylic acid and/or cis- and/or trans-cyclohexane-1,3-dicarboxylic acid (CHDA).

According to preferred embodiments of the present invention, the aliphatic dicarboxylic acid is trans-cyclohexane-1,4-dicarboxylic acid.

Non limitative examples of aliphatic diamines are typically aliphatic alkylene diamines having 2 to 18 carbon atoms, which are advantageously selected from the group consisting of 1,2-diaminoethane, 1,2-diaminopropane, propylene-1,3-diamine, 1,3-diaminobutane, 1,4-diaminobutane, 1,5-diaminopentane, 1,4-diamino-1,1-dimethylbutane, 1,4-diamino-1-ethylbutane, 1,4-diamino-1,2-dimethylbutane, 1,4-diamino-1,3-dimethylbutane, 1,4-diamino-1,4-dimethylbutane, 1,4-diamino-2,3-dimethylbutane, 1,2-diamino-1-butylethane, 1,6-diaminohexane, 1,7-diaminoheptane, 1,8-diamino-octane, 1,6-diamino-2,5-dimethylhexane, 1,6-diamino-2,4-dimethylhexane, 1,6-diamino-3,3-dimethylhexane, 1,6-diamino-2,2-dimethylhexane, 2-methyl-1,8-diaminooctane, 1,9-diaminononane, 1,6-diamino-2,2,4-trimethylhexane, 1,6-diamino-2,4,4-trimethylhexane, 1,7-diamino-2,3-dimethylheptane, 1,7-diamino-2,4-dimethylheptane, 1,7-diamino-2,5-dimethylheptane, 1,7-diamino-2,2-dimethylheptane, 1,10-diaminodecane, 1,8-diamino-1,3-dimethyloctane, 1,8-diamino-1,4-dimethyloctane, 1,8-diamino-2,4-dimethyloctane, 1,8-diamino-3,4-dimethyloctane, 1,8-diamino-4,5-dimethyloctane, 1,8-diamino-2,2-dimethyloctane, 1,8-diamino-3,3-dimethyloctane, 1,8-diamino-4,4-dimethyloctane, 1,6-diamino-2,4-diethylhexane, 1,9-diamino-5-methylnonane, 1,11-diaminoundecane and 1,12-diaminododecane.

Also, the aliphatic diamine may be chosen from cycloaliphatic diamines such as isophorone diamine (also known as 5-amino-(1-aminomethyl)-1,3,3-trimethylcyclohexane), 1,3-cyclohexanebis(methylamine) (1,3-BAMC), 1,4-cyclohexanebis(methylamine) (1,4-BAMC), 4,4-diaminodicyclohexylmethane (PACM), and bis(4-amino-3-methylcyclohexyl)methane.

According to preferred embodiments of the present invention, the aliphatic diamine is selected from the group consisting of 1,9-diaminononane, 2-methyl-1,8-diaminooctane, 1,10-diaminodecane, 1,11-diaminoundecane, 1,12-diaminododecane and mixtures thereof.

In addition, aromatic aminocarboxylic acids or derivatives thereof may also be used for the manufacture of the polyamide of the polymer composition (C), which is generally selected from the group consisting of 4-(aminomethyl)benzoic acid and 4-aminobenzoic acid, 6-aminohexanoic acid, 1-aza-2-cyclononanone, 1-aza-2-cyclododecanone, 11-aminoundecanoic acid, 12-aminododecanoic acid, 4-(aminomethyl)benzoic acid, cis-4-(aminomethyl)cyclohexanecarboxylic acid, trans-4-(aminomethyl)cyclohexanecarboxylic acid, cis-4-aminocyclohexanecarboxylic acid and trans-4-aminocyclohexanecarboxylic acid.

Non limitative examples of aliphatic lactams are notably selected from the group consisting of caprolactam and lauryl lactam.

The polyamide (PA) of the polymer composition (C) comprises at least 50 mol % of recurring units comprising an aliphatic moiety comprising at least 9 carbon atoms.

The recurring units comprising an aliphatic moiety comprising at least 9 carbon atoms may be formed by the polycondensation of at least one aliphatic dicarboxylic acid with at least one aliphatic diamine or by the polycondensation of at least one aliphatic dicarboxylic acid with at least one aromatic diamine, or by the polycondensation of at least one aromatic dicarboxylic acid with at least one aliphatic diamine or by the polycondensation of aminocarboxylic acids.

The aliphatic moiety comprising at least 9 carbon atoms present in the recurring units of the polyamide (PA) may be derived from aliphatic dicarboxylic acids and/or aliphatic diamines detailed hereafter.

Notable examples of aliphatic dicarboxylic acids comprising an aliphatic moiety comprising at least 9 carbon atoms are azelaic acid [HOOC-(CH$_2$)$_7$-COOH], sebacic acid [HOOC-(CH$_2$)$_8$-COOH], undecanedioic acid [HOOC-(CH$_2$)$_9$-COOH], dodecanedioic acid [HOOC-(CH$_2$)$_{10}$-COOH], tetradecanedioic acid [HOOC-(CH$_2$)$_{11}$-COOH]. Among them, azelaic acid [HOOC-(CH$_2$)$_7$-COOH], sebacic acid [HOOC-(CH$_2$)$_8$-COOH], dodecanedioic acid [HOOC-(CH$_2$)$_{10}$-COOH] are preferred.

Notable examples of aliphatic diamines comprising an aliphatic moiety comprising at least 9 carbon atoms are 1,9-diaminononane, 2-methyl-1,8-diaminooctane, 1,6-diamino-2,2,4-trimethylhexane, 1,6-diamino-2,4,4-trimethylhexane, 1,7-diamino-2,3-dimethylheptane, 1,7-diamino-2,4-dimethylheptane, 1,7-diamino-2,5-dimethylheptane, 1,7-diamino-2,2-dimethylheptane, 1,10-diaminodecane, 1,8-diamino-1,3-dimethyloctane, 1,8-diamino-1,4-dimethyloctane, 1,8-diamino-2,4-dimethyloctane, 1,8-diamino-3,4-dimethyloctane, 1,8-diamino-4,5-dimethyloctane, 1,8-diamino-2,2-dimethyloctane, 1,8-diamino-3,3-dimethyloctane, 1,8-diamino-4,4-dimethyloctane, 1,6-diamino-2,4-diethylhexane, 1,9-diamino-5-methylnonane, 1,11-diaminoundecane and 1,12-diaminododecane. Among them, 1,9-diaminononane, 1,10-diaminodecane, 1,12-diaminododecane are preferred. Excellent results were obtained when using 1,9-diaminononane.

Non limitative examples of polyamides (PA) of the polymer composition (C) are: the polymer of terephthalic acid with 1,9-diaminononane and/or 2-methyl-1,8-diaminooctane, the polymer of 1,4-cyclohexanedicarboxylic acid with 1,9-diaminononane and/or 2-methyl-1,8-diaminooctane" the polymer of terephthalic acid with 1,10-decamethylene diamine, the polymer of terephthalic acid with dodecamethylene diamine, the copolymer of terephthalic acid with hexamethylene diamine and decamethylene diamine; the copolymer of terephthalic acid and isophthalic acid with hexamethylene diamine and decamethylene diamine; the copolymer of terephthalic acid with decamethylene diamine and 11-amino-undecanoic acid, the copolymer of terephthalic acid with hexamethylene diamine and 11-amino-undecanoic acid; the copolymer of hexamethylene diamine with terephthalic acid and sebacic acid; the copolymer of hexamethylene diamine with terephthalic acid and 1,12-diaminododecanoic acid; the copolymer of decamethylene diamine with terephthalic acid and 4-aminocyclohexanecarboxylic acid; the copolymer of decamethylene diamine with terephthalic acid and 4-(aminomethyl)-cyclohexanecarboxylic acid; the polymer of decamethylene diamine with 2,6-napthalenedicarboxylic acid; the copolymer of 2,6-napthalenedicarboxylic acid with hexamethylene diamine and decamethylene diamine; the copolymer of 2,6-napthalenedicarboxylic acid with hexamethylene diamine and decamethylene diamine; the polymer of decamethylene diamine with 1,4-cyclohexanedicarboxylic acid, the copolymer of hexamethylene diamine with 11-amino-undecanoic acid and 2,6-napthalenedicarboxylic acid; the copolymer of terephthalic acid with decamethylene diamine and 2-methylpentamethylene diamine; the copolymer of 1,4-cyclohexanedicarboxylic acid with decamethylene diamine.

The polyamide (PA) is preferably selected from the group consisting of the polymer of terephthalic acid with 1,9-diaminononane and/or 2-methyl-1,8-diaminooctane, the polymer of 1,4-cyclohexanedicarboxylic acid with 1,9-diaminononane and/or 2-methyl-1,8-diaminooctane, the polymer of terephthalic acid with 1,10-decamethylene diamine, and the polymer of 1,4-cyclohexanedicarboxylic acid with 1,10-decamethylene diamine.

The polyamide (PA) has a melting point, as measured by DSC according to ISO-11357-3, of advantageously at least 250°C, preferably at least 260°C, more preferably at least 270°C and most preferably at least 280°C. Besides, its melting point is advantageously of at most 350°C, preferably at most 340°C, more preferably at most 330°C and most preferably at most 320°C. Excellent results were obtained with a polyamide (PA) having a melting point ranging from 280°C to 320°C.

The polyamide (PA) is preferably present in an amount of at least 0.5 wt. %, more preferably at least 1 wt. %, still more preferably at least 1.5 wt. %, and most preferably at least 2 wt. %, based on the total weight of the polymer composition (C).

The polyamide (PA) is also present in an amount of advantageously at most 20 wt. %, preferably at most 15 wt. %, more preferably at most 10 wt. %, still more preferably at most 8 wt. %, and most preferably at most 6 wt. %, based on the total weight of the polymer composition (C).

Excellent results were obtained when the polyamide (PA) was present in the polymer composition (C) in an amount from about 1 to about 10 wt. %, preferably from about 2 to about 6 wt. %, based on the total weight of the polymer composition (C).

The polymer composition (C) may comprise more than one polyamide (PA).

*The white pigment*

The polymer composition (C) may also comprise at least one white pigment selected from the group consisting of $TiO_2$, $ZnS$, $ZnO$, $CeO_2$ and $BaSO_4$.

The white pigment is preferably titanium dioxide ($TiO_2$). The form of titanium dioxide is not particularly limited and a variety of crystalline forms such as the anatase form, the rutile form, and the monoclinic type can be used. However, the rutile form is preferred due to its higher refraction index and its superior light stability. Titanium dioxide may or may not be treated with a surface treatment agent. The surface of the titanium dioxide particles will preferably be coated. The titanium dioxide will preferably be first coated with an inorganic coating and then with an organic coating. The titanium dioxide particles may be coated using any method known in the art. Preferred inorganic coatings include metal oxides. Organic coatings may include one or more of carboxylic acids, polyols, alkanolamines, and/or silicon compounds.

If present, the white pigment is preferably present in an amount of at least 5 wt. %, preferably of at least 10 wt. %, more preferably of at least 15 wt. %, even more preferably of at least 20 wt. %, and most preferably of at least 25 wt. %, based on the total weight of the polymer composition (C). Besides, the white pigment is also preferably present in an amount of at most 60 wt. %, preferably of at most 50 wt. %, more preferably of at most 45 wt. %, even more preferably of at most 40 wt. %, and most preferably of at most 35 wt. %, based on the total weight of the polymer composition (C). Good results were obtained when the white pigment was used in an amount of 10-60 wt. %, preferably of 20-40 wt. %, based on the total weight of the polymer composition (C).

Excellent results were obtained when titanium dioxide was used in an amount of 10-50 wt. %, preferably of 20-40 wt. %, based on the total weight of the polymer composition (C).

*The reinforcing filler*

The polymer composition (C) may also further comprise at least one reinforcing filler.

Reinforcing fillers are preferably fibrous. More preferably, the reinforcing filler is selected from glass fiber, carbon fiber, synthetic polymeric fiber, aramid fiber, aluminum fiber, titanium fiber, magnesium fiber, boron carbide fibers, rock wool fiber, steel fiber, wollastonite, etc. Still more preferably, it is selected from glass fiber, carbon fiber and wollastonite.

A particular class of fibrous fillers consists of whiskers, i.e. single crystal fibers made from various raw materials such as $Al_2O_3$, SiC, BC, Fe and Ni. Among fibrous fillers, glass fibers are preferred; they include chopped strand A-, E-, C-, D-, S- T- and R-glass fibers, as described in chapter 5.2.3, p. 43-48 of Additives for Plastics Handbook, 2nd ed., John Murphy.

In a preferred embodiment of the present invention the reinforcing filler is chosen from wollastonite and glass fiber. Glass fibers may have a round cross-section or an elliptic cross-section (also called flat fibers).

If present, the reinforcing filler is preferably present in an amount of at least 2 wt. %, more preferably at least 4 wt. %, still more preferably at least 5 wt. %, and most preferably at least 10 wt. %, based on the total weight of the polymer composition (C). When present, the reinforcing filler is also preferably present in an amount of at most 40 wt. %, more preferably at most 30 wt. %, still more preferably at most 25 wt. %, and most preferably at most 20 wt. %, based on the total weight of the polymer composition (C).

Excellent results were obtained when the reinforcing filler was present in the composition in an amount from about 5 to about 40 wt. %, preferably from about 5 to about 25 wt. %, and more preferably from about 10 to about 20 wt. %, based on the total weight of the polymer composition (C).

*Optional ingredients*

The polymer composition (C) may also further comprise at least another polyester, different from the above mentioned polyester (P), which may be selected from the group consisting of: polyglycolide or polyglycolic acid (PGA), polylactic acid (PLA), polycaprolactone (PCL), polyethylene adipate (PEA), polyhydroxyalkanoate (PHA), polybutylene terephthalate (PBT), polypropylene terephthalate (PPT), polytrimethylene terephthalate (PTT), polyethylene naphthalate (PEN), polybutylene naphthalate(PBN), polyethylene terephthalate (PET), and Liquid Crystalline Polyesters (LCP). It is preferably selected from the group consisting of PBT, PTT, PEN, PET and LCP. More preferably, it is selected from the group consisting of PBT and LCP.

When added to the polymer composition (C), the other polyester different from the polyester (P) is preferably present in an amount of at least 1 wt. %, preferably of at least 2 wt. %, more preferably of at least 3 wt. %, even more preferably of at least 4 wt. %, and most preferably of at least 5 wt. %, based on the total weight of the polymer composition (C). Besides, the other polyester is also preferably present in an amount of at most 20 wt. %, preferably of at most 15 wt. %, more preferably of at most 10 wt. %, even more preferably of at most 9 wt. %, and most preferably of at most 8 wt. %, based on the total weight of the polymer composition (C).

The polymer composition (C) may also further comprise at least another polyamide, different from the above mentioned polyamide (PA), which may notably be selected from the group consisting of PA6T, PA 6T/6I, PA6,6, and PA6.

When added to the polymer composition (C), the other polyamide different from the polyamide (PA) is preferably present in an amount of at least 1 wt. %, preferably of at least 2 wt. %, more preferably of at least 3 wt. %, even more preferably of at least 4 wt. %, and most preferably of at least 5 wt. %, based on the total weight of the polymer composition (C). Besides, the other polyamide is also preferably present in an amount of at most 20 wt. %, preferably of at most 15 wt. %, more preferably of at most 10 wt. %, even more preferably of at most 9 wt. %, and most preferably of at most 8 wt. %, based on the total weight of the polymer composition (C).

The polymer composition (C) can further contain one or more impact modifiers. The impact modifiers can be reactive with the polyester (P) and/or the polyamide (PA) or non-reactive. In certain specific embodiment, the polymer composition (C) contains at least one reactive impact modifier and at least one non-reactive impact modifier.

Reactive impact modifiers that may be used include ethylene-maleic anhydride copolymers, ethylene-alkyl (meth)acrylate-maleic anhydride copolymers, ethylene-alkyl (meth)acrylate-glycidyl (meth)acrylate copolymers, and the like. An example of such reactive impact modifier is a random terpolymer of ethylene, methylacrylate and glycidyl methacrylate.

Non-reactive impact modifiers that may be blended into the polymer composition (C) generally include various rubber materials, such as acrylic rubbers, ASA rubbers, diene rubbers, organosiloxane rubbers, EPDM rubbers, SBS or SEBS rubbers, ABS rubbers, NBS rubbers and the like. Particular examples of non-reactive impact modifiers include ethyl butylacrylate, ethyl (methyl)acrylate or 2 ethyl hexyl acrylate copolymers.

If present, the impact modifier is preferably present in an amount of at least 0.5 wt. %, more preferably at least 0.7 wt. %, still more preferably at least 0.9 wt. %, and most preferably at least 1 wt. %, based on the total weight of the polymer composition (C). When present, the impact modifier is also preferably present in an amount of at most 5 wt. %,

more preferably at most 4 wt. %, still more preferably at most 3 wt. %, and most preferably at most 2 wt. %, based on the total weight of the polymer composition (C).

The polymer composition (C) may optionally further contain up to about 3 wt. % of ultraviolet light stabilizers or UV blockers. Examples include hindered amines, triazoles and triazines, oxanilides, hydroxybenzophenones, benzoates, and α-cyanoacrylates. When present, the ultraviolet light stabilizers are preferably present in an amount of about 0.1 to about 3 wt. %, or preferably about 0.1 to about 1 wt. %, or more preferably about 0.1 to about 0.6 wt. %, of the total weight of the polymer composition (C).

The polymer composition (C) may also comprise other optional ingredients such as mold release agents, lubricants, fillers, optical brighteners and other stabilizers, different from the ones described above.

As described above, the polymer composition (C) has excellent reflectance properties. For example, the polymer composition (C) can have an initial reflectance at 460 nm of greater than about 85 %, preferably greater than about 86 %, more preferably greater than about 88 %, still more preferably greater than about 90 %, as measured according to ASTM E-1331-09 using a D65 illuminant with a 10° observer.

Any melt-mixing method may be used to combine the polymeric components and non-polymeric ingredients to prepare the polymer composition (C). For example, the polymeric components and non-polymeric ingredients may be added to a melt mixer, such as, for example, a single or twinscrew extruder, a blender or a Branbury mixer, either all at once through a single step addition, or in a stepwise fashion, and then melt-mixed. When adding the polymeric components and non-polymeric ingredients in a stepwise fashion, part of the polymeric components and/or non-polymeric ingredients are first added and melt-mixed with the remaining polymeric components and non-polymeric ingredients are subsequently added and further melt-mixed until a well-mixed composition is obtained.

A further aspect of the present invention relates thus to a process for the manufacture of the polymer composition (C).

An aspect of the present invention also provides an article comprising at least one part comprising the polymer composition (C), which provides various advantages over prior art parts and articles, in particular an increased whiteness, even after exposure to heat and/or light while maintaining all their other properties at a high level.

In a particular embodiment, the article is a light emission apparatus.

Non limitative examples of light emission apparatuses are keyless entry systems of an automobile, lightings in a refrigerator, liquid crystal display apparatuses, automobile front panel lighting apparatuses, desk lamps, headlights, household electrical appliance indicators and outdoor display apparatuses such as traffic signs, and optoelectronic devices comprising at least one semi-conductor chip that emits and/or transmits electromagnetic radiation commonly known as Light Emitting Diodes devices (LEDs). Preferably, the light emission apparatus is a LED device.

As used herein, the terms "light emitting diode device" and "LED device" intend to denote a device comprising at least one light emitting diode, an electrical connection capable of connecting the diode to an electrical circuit, and a housing partially surrounding the diode. The LED device may optionally have a lens that fully or partially covers the LED.

LEDs are preferably chosen from the group of top view LEDs, side view LEDs and power LEDs. The top view LEDs are notably used in automotive lighting applications such as panel displays, stop lights and turn signals. The side view LEDs are notably used for mobile appliance applications such as, for example, cell phones and PDAs. The power LEDs are notably used in flashlights, automotive day light running lights, signs and as backlight for LCD displays and TVs.

The articles of the present invention may be incorporated into LED devices used in applications such as traffic signals, large area displays, video screens, interior and exterior lighting, cellular telephone display backlights, automotive displays, vehicle brake lights, vehicle head lamps, laptop computer display backlights, pedestrian floor illumination and flashlights.

The articles of the present invention are preferably parts of a LED device such as housings, reflectors and heatsinks.

The articles prepared from the polymer composition (C) may be manufactured by any suitable melt-processing method known to those skilled in the art, such as injection molding or the like.

The articles may be overmolded over a metal (such as copper or silver-coated copper) lead frame that can be used to make an electrical connection to an LED inserted into the housing. The article preferably has a cavity in the portion of the housing that surrounds the LED, which serves to reflect the LED light in the outward direction and towards a lens, if one is present. The cavity may be in a cylindrical, conical, parabolic or other curved form, and preferably has a smooth surface. Alternatively, the walls of the cavity may be parallel or substantially parallel to the diode. A lens may be formed over the diode cavity and may comprise an epoxy or silicone material.

Preferably at least 50 wt. % and more preferably more than 80 wt. % of the part comprises the polymer composition (C) (the part can possibly further contain notably a metal; for example, for certain end uses, the surface of the part acting as reflector may be metal plated). More preferably, more than 90 wt. % of the part comprises the polymer composition (C). Still more preferably, the part consists essentially of the polymer composition (C). The most preferably, the part consists of the polymer composition (C).

## EXAMPLES

The disclosure will now be illustrated with working examples, which are intended to illustrate the present invention and are not intended to restrictively imply any limitations on the scope of the present disclosure.

The following commercially available materials were used :

*Polyester :* PCT Polyester from Eastman™ Chemical Products.
*Polyamide :* PA 9T (GC51010) from Kuraray Co., LTD.
*Wollastonite : SH-1250* commercially available from Kinsei Matec Co., LTD.
*Titanium Dioxide :* TIPAQUE® PF691 available from Ishihara Sangyo Kaisha, LTD.

### General procedure for the preparation of the compositions

The polyester and polyamide resins described above were fed to the first barrel of a ZSK-26 twin screw extruder comprising 12 zones via a loss in weight feeder. The barrel set-point temperatures were in the range of 150-320°C and the resins were melted before zone 5. The other solid ingredients were fed at zone 5 through a side stuffer via a loss in weight feeder. The screw rate was in the range of 150-250 rpm. The extrudates were cooled and pelletized using conventional equipment.

The nature and quantity of the various ingredients used are summarized in Table 1, indicating the amount of each ingredient in weight percent.

### Reflectance measurements

Behavior of a part made from the inventive composition in a LED device was studied by exposing samples at 260°C for 10 minutes to simulate part of the LED manufacturing process. Therefore, each one of the compositions of examples E3 and E4 and comparative examples CE1 and CE2 were used to prepare discs of about 60 mm diameter with a thickness of about 1 mm.

Reflectances were measured on a BKY-Gardner photo-spectrometer according to ASTM E-1331-09 using a D65 illuminant with a 10° observer. The average reflectance results on the original molded parts and on the same parts after exposure to high heat (260°C for 10 minutes for the discs) obtained on at least 10 samples are summarized in Table 2, as well as the percentages of retention of reflectance at a wavelength of 460 nm.

**Table 1 : Nature and quantity in weight % of the ingredients used**

|  | (CE1) | (CE2) | (E3) | (E4) |
|---|---|---|---|---|
| **Polyester** | 51.76 | - | **49.26** | **46.76** |
| **Polyamide** | - | 54.76 | **2.5** | **5** |
| **White pigment 1** | 27.5 | 27.5 | **27.5** | **27.5** |
| **Reinforcing filler** | 15 | 15 | **15** | **15** |
| **Additive package** | 5.74 | 2.74 | **5.74** | **5.74** |
|  |  |  |  |  |
| **Ratio polyester/total amount of resin (Rp)** | 1 | 0 | **0.952** | **0.903** |

**Table 2 : Reflectance measurements on discs after heat treatment at 260°C**

| **Reflectance at 460 nm (%)** | (CE1) | (CE2) | **(E3)** | **(E4)** |
|---|---|---|---|---|
| - as molded | 95.8 | 98.1 | **97.5** | **97.7** |
| - after 10 min at 260°C | 94.4 | 87.3 | **95.2** | **94.9** |
|  |  |  |  |  |
| - as molded CALCULATED |  |  | **95.9** | **96.0** |
| - after 10 min at 260°C CALCULATED |  |  | **94.0** | **93.7** |

**Results**

CE1 exhibited good reflectance as molded and very high reflectance retention after heat aging.

On the other hand, CE2 presented higher reflectance as molded and unsatisfactory reflectance retention after heat aging.

In Table 2, expected values of the reflectance as molded and after heat aging were calculated using the following equation:

$$Rf(E) = (Rf(CE1) * Rp) + (Rf(CE2) * (1- Rp))$$

where

Rf is the reflectance (as molded or after heat aging), and
Rp is the ratio of the weight of the polyester over the total weight amount of resin in the composition.

As it may be seen from the data presented in Table 2, the compositions according to the present invention (E3 and E4) surprisingly featured higher reflectance as molded than the expected calculated value based on the weight average of the polyester and the polyamide in the composition.

In addition, it was unexpectedly observed that the reflectance after heat aging (10 minutes at 260°C) was also higher than the calculated values for those compositions.

The compositions according to the present invention present thus high reflectance of light, high whiteness, high dimensional stability, high mechanical strength, high heat deflection temperature, and high heat resistance (low discoloration and low loss of reflectance when exposed to a high temperature) and are therefore very well suited for the manufacture of LED's.

**Claims**

1. A polymer composition (C) comprising :

   - from 20 to 60 wt. % of at least one polyester (P) comprising at least 50 mol % of recurring units comprising at least one cycloaliphatic group,
   - from 0.5 to 20 wt. % of at least one polyamide (PA) comprising at least 50 mol % of recurring units comprising an aliphatic moiety comprising at least 9 carbon atoms,
   - from 0 to 60 wt. % of at least one white pigment selected from the group consisting of $TiO_2$, ZnS, ZnO, $CeO_2$ and $BaSO_4$,
   - from 0 to 60 wt. % of at least one reinforcing filler,

   based on the total weight of the polymer composition (C).

2. The polymer composition (C) according to claim 1, wherein the polyester (P) is present in an amount of from 30 to 60 wt. %, based on the total weight of the composition.

3. The polymer composition (C) according to anyone of the preceding claims, wherein at least 50 mol % of the recurring units of the polyester (P) are obtained through the polycondensation of terephthalic acid with 1,4-cyclohexylenedimethanol.

4. The polymer composition (C) according to anyone of the preceding claims, wherein the polyester (P) is poly(1,4-cyclohexylenedimethylene terephthalate).

5. The polymer composition (C) according to anyone of the preceding claims, wherein the polyamide (PA) is selected from the group consisting of the polymer of terephthalic acid with 1,9-diaminononane and/or 2-methyl-1,8-diaminooctane, the polymer of 1,4-cyclohexanedicarboxylic acid with 1,9-diaminononane and/or 2-methyl-1,8-diaminooctane, the polymer of terephthalic acid with 1,10-decamethylene diamine, and the polymer of 1,4-cyclohexanedicarboxylic acid with 1,10-decamethylene diamine.

**6.** The polymer composition (C) according to anyone of the preceding claims, wherein the polyamide (PA) is present in the polymer composition (C) in an amount of from 1 to 10 wt. %.

**7.** The polymer composition (C) according to anyone of the preceding claims, wherein the white pigment is present in an amount of from 10 to 60 wt. %.

**8.** The polymer composition (C) according to anyone of the preceding claims, wherein the white pigment is $TiO_2$.

**9.** The polymer composition (C) according to anyone of the preceding claims, wherein it further comprises at least one reinforcing filler selected from the group consisting of glass fiber and wollastonite.

**10.** The polymer composition (C) according to claim 9, wherein the reinforcing filler is present in an amount of from 5 to 40 wt. %, based on the total weight of the polymer composition (C).

**11.** An article comprising at least one part comprising the polymeric composition (C) according to any one of the preceding claims.

**12.** The article according to claim 11, wherein the article is a light emitting diode (LED) device.

**13.** The article according to claim 11, wherein the part is a reflector.


**Patentansprüche**

**1.** Polymerzusammensetzung (C), umfassend

- 20 bis 60 Gew.- % mindestens eines Polyesters (P) mit mindestens 50 Mol- % Wiederholungseinheiten mit mindestens einer cycloaliphatischen Gruppe,
- 0,5 bis 20 Gew.- % mindestens eines Polyamids (PA) mit mindestens 50 Mol- % Wiederholungseinheiten mit einer aliphatischen Gruppierung mit mindestens 9 Kohlenstoffatomen,
- 0 bis 60 Gew.- % mindestens eines Weißpigments aus der Gruppe bestehend aus $TiO_2$, ZnS, ZnO, $CeO_2$ und $BaSO_4$,
- 0 bis 60 Gew.- % mindestens eines verstärkenden Füllstoffs,

bezogen auf das Gesamtgewicht der Polymerzusammensetzung (C).

**2.** Polymerzusammensetzung (C) nach Anspruch 1, wobei der Polyester (P) in einer Menge von 30 bis 60 Gew.- %, bezogen auf das Gesamtgewicht der Zusammensetzung, vorliegt.

**3.** Polymerzusammensetzung (C) nach einem der vorhergehenden Ansprüche, wobei mindestens 50 Mol- % der Wiederholungseinheiten des Polyesters (P) durch Polykondensation von Terephthalsäure mit 1,4-Cyclohexylendimethanol erhalten werden.

**4.** Polymerzusammensetzung (C) nach einem der vorhergehenden Ansprüche, wobei es sich bei dem Polyester (P) um Poly(1,4-cyclohexylendimethylenterephthalat) handelt.

**5.** Polymerzusammensetzung (C) nach einem der vorhergehenden Ansprüche, wobei das Polyamid (PA) aus der Gruppe bestehend aus dem Polymer von Terephthalsäure mit 1,9-Diaminononan und/oder 2-Methyl-1,8-diaminooctan, dem Polymer von 1,4-Cyclohexandicarbonsäure mit 1,9-Diaminononan und/oder 2-Methyl-1,8-diaminooctan, dem Polymer von Terephthalsäure mit 1,10-Decamethylendiamin und dem Polymer von 1,4-Cyclohexandicarbonsäure mit 1,10-Decamethylendiamin ausgewählt ist.

**6.** Polymerzusammensetzung (C) nach einem der vorhergehenden Ansprüche, wobei das Polyamid (PA) in der Polymerzusammensetzung (C) in einer Menge von 1 bis 10 Gew.- % vorliegt.

**7.** Polymerzusammensetzung (C) nach einem der vorhergehenden Ansprüche, wobei das Weißpigment in einer Menge von 10 bis 60 Gew.- % vorliegt.

**8.** Polymerzusammensetzung (C) nach einem der vorhergehenden Ansprüche, wobei es sich bei dem Weißpigment um $TiO_2$ handelt.

**9.** Polymerzusammensetzung (C) nach einem der vorhergehenden Ansprüche, wobei sie ferner mindestens einen verstärkenden Füllstoff aus der Gruppe bestehend aus Glasfaser und Wollastonit umfasst.

**10.** Polymerzusammensetzung (C) nach Anspruch 9, wobei der verstärkende Füllstoff in einer Menge von 5 bis 40 Gew.- %, bezogen auf das Gesamtgewicht der Polymerzusammensetzung (C), vorliegt.

**11.** Artikel, umfassend mindestens ein Teil, das die Polymerzusammensetzung (C) nach einem der vorhergehenden Ansprüche umfasst.

**12.** Artikel nach Anspruch 11, wobei es sich bei dem Artikel um eine Leuchtdiodenvorrichtung (LED-Vorrichtung) handelt.

**13.** Artikel nach Anspruch 11, wobei es sich bei dem Teil um einen Reflektor handelt.


**Revendications**

**1.** Composition de polymères (C) comprenant :

- de 20 à 60 % en poids d'au moins un polyester (P) comprenant au moins 50 % en mole de motifs récurrents comprenant au moins un groupe cycloaliphatique,
- de 0,5 à 20 % en poids d'au moins un polyamide (PA) comprenant au moins 50 % en mole de motifs récurrents comprenant une fraction aliphatique comprenant au moins 9 atomes de carbone,
- de 0 à 60 % en poids d'au moins un pigment blanc choisi dans le groupe constitué par $TiO_2$, ZnS, ZnO, $CeO_2$ et $BaSO_4$,
- de 0 à 60 % en poids d'au moins une charge renforçante,

par rapport au poids total de la composition de polymères (C).

**2.** Composition de polymères (C) selon la revendication 1, le polyester (P) étant présent en une quantité de 30 à 60 % en poids, par rapport au poids total de la composition.

**3.** Composition de polymères (C) selon l'une quelconque des revendications précédentes, au moins 50 % en mole des motifs récurrents du polyester (P) étant obtenus par la polycondensation d'acide téréphtalique avec du 1,4-cyclohexylènediméthanol.

**4.** Composition de polymères (C) selon l'une quelconque des revendications précédentes, le polyester (P) étant le poly(téréphtalate de 1,4-cyclohexylènediméthylène).

**5.** Composition de polymères (C) selon l'une quelconque des revendications précédentes, le polyamide (PA) étant choisi dans le groupe constitué par le polymère d'acide téréphtalique avec le 1,9-diaminononane et/ou le 2-méthyl-1,8-diaminooctane, le polymère d'acide 1,4-cyclohexanedicarboxylique avec le 1,9-diaminononane et/ou le 2-méthyl-1,8-diaminooctane, le polymère d'acide téréphtalique avec la 1,10-décaméthylènediamine et le polymère d'acide 1,4-cyclohexanedicarboxylique avec la 1,10-décaméthylènediamine.

**6.** Composition de polymères (C) selon l'une quelconque des revendications précédentes, le polyamide (PA) étant présent dans la composition de polymères (C) en une quantité de 1 à 10 % en poids.

**7.** Composition de polymères (C) selon l'une quelconque des revendications précédentes, le pigment blanc étant présent en une quantité de 10 à 60 % en poids.

**8.** Composition de polymères (C) selon l'une quelconque des revendications précédentes, le pigment blanc étant $TiO_2$.

**9.** Composition de polymères (C) selon l'une quelconque des revendications précédentes, celle-ci comprenant en outre au moins une charge renforçante choisie dans le groupe constitué par la fibre de verre et la wollastonite.

**10.** Composition de polymères (C) selon la revendication 9, la charge renforçante étant présente en une quantité de 5 à 40 % en poids, par rapport au poids total de la composition de polymères (C).

**11.** Article comprenant au moins une pièce comprenant la composition polymère (C) selon l'une quelconque des revendications précédentes.

**12.** Article selon la revendication 11, l'article étant un dispositif à diodes électroluminescentes (DEL).

**13.** Article selon la revendication 11, la pièce étant un réflecteur.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2007033129 A
- US 20120262927 A

- WO 2012141967 A

**Non-patent literature cited in the description**

- **JOHN MURPHY.** Additives for Plastics Handbook. 43-48